# EUROPÄISCHE PATENTSCHRIFT

(11) **EP 1 490 899 B1**
(45) Veröffentlichungstag und Bekanntmachung des Hinweises auf die Patenterteilung: **13.09.2017**
(21) Anmeldenummer: 03760590.4
(22) Anmeldetag: 27.05.2003
(51) Int. Cl.: H01L 21/3213, C09D 9/00, C09G 1/04, G03F 7/42

(54) **ZUSAMMENSETZUNG ZUM ENTFERNEN VON "SIDEWALL-RESIDUES"**
COMPOSITION FOR REMOVING SIDEWALL RESIDUES
COMPOSITION POUR ELIMINER DES RESIDUS DE PAROI LATERALE

(30) Priorität: 22.06.2002 DE 10227867
(43) Veröffentlichungstag der Anmeldung: 29.12.2004
(73) Patentinhaber: BASF SE, 67056 Ludwigshafen am Rhein (DE)
(72) Erfinder: MELLIES, Raimund, 64807 Dieburg (DE); BÖRNER, Marc, 64283 Darmstadt (DE); ARNOLD, Lucia, 64839 Münster (DE); BARKO, Andrea, 63811 Stockstadt (DE); RHEIN, Rudolf, 64646 Heppenheim (DE)
(74) Vertreter: BASF IP Association
(86) Internationale Anmeldenummer: PCT/EP2003/005549
(87) Internationale Veröffentlichungsnummer: WO 2004/001834

(56) Entgegenhaltungen:
- EP-A- 0 477 504
- EP-A- 0 811 666
- WO-A-97/36209
- US-B1- 6 273 959
- US-B1- 6 399 552

## Beschreibung

Die vorliegende Erfindung betrifft eine Zusammensetzung zum Entfernen von sogenannten "sidewall-residues" von Metalloberflächen, insbesondere von Aluminium oder aluminiumhaltigen Oberflächen während der Herstellung von Halbleiterelementen.

### Stand der Technik:

Leiterbahnen in integrierten Schaltkreisen bestehen hauptsächlich aus Aluminium bzw. aus einer Aluminium-Kupfer-Legierung (0,5 % Kupfer), das ganzflächig durch Sputtern abgeschieden wird. Anschließend werden die Strukturen mittels Fotolackbeschichtung, Belichten und Entwickeln abgebildet. Im nachfolgenden Trockenätzprozess wird das Aluminium strukturiert, wobei sich u.a. aus Bestandteilen des Fotolacks und der Ätzgase Polymere bilden, die sich vorwiegend an den Seitenwänden der Aluminiumleiterzüge als geschlossene Schicht ablagern. Auch nach dem Entfernen des Photolacks mittels Sauerstoffplasma oder Carotscher Säure verbleiben diese Polymere auf den Leiterbahnen. Diese sogenannten Restpolymere, die im allgemeinen als "sidewall residues" bezeichnet werden, müssen vor der Fortsetzung der Herstellungsprozesses vollständig entfernt werden, um die Funktion und die Zuverlässigkeit des IC-Bauteils zu gewährleisten. Im folgenden werden diese "sidewall residues" als Restpolymere bezeichnet.

Die Entfernung der Restpolymere geschieht nach üblichen Verfahren durch einen Nassreinigungsschritt mittels einer Lösung, die als Stripper oder Stripperlösung bezeichnet wird. Konventionelle Stripper enthalten einen Komplexbildner, einen Korrosionsinhibitor, und ein polares Lösungsmittel. In dem Produkt EKC 265, welches am häufigsten benutzt wird, sind diese Komponenten Hydroxylamin, Mono-Ethanolamin, Katechol und Wasser.

Neuere Entwicklungen haben dazu geführt, dass auch rein anorganische Stripper eingesetzt werden können. Beispielsweise werden in WO 97/36209 A1 (Merck) Zusammensetzungen basierend auf verdünnten Schwefelsäure-Wasserstoffperoxid-Lösungen (DSP) beschrieben. In US 5,698,503 und 5,709,756 wiederum werden entsprechende Stripper basierend auf Ammoniumfluorid-Lösungen verwendet.

Verdünnte Schwefelsäure - Wasserstoffperoxidlösungen (DSP) reichen zum Entfernen der Restpolymere allein nicht aus und enthalten daher zusätzliche Additive. Solche Additive sind z. B. geringe Mengen Flusssäure im Konzentrationsbereich von 10 bis 100 mg/kg. Die Flusssäure wirkt auf Aluminium und Aluminium/Kupferlegierungen leicht ätzend. Der Angriff erfolgt flächig ohne die Metallisierung zu beschädigen. Eine Lochkorrosion, wie beispielsweise durch Chloridionen, findet nicht statt.

Durch das Unterätzen trennt sich die Restpolymerschicht von der Metalloberfläche ab und wird durch die Flüssigkeit fortgespült (lift-off). Die durch den Ätzvorgang freigelegte Metalloberfläche wird anschließend durch das Wasserstoffperoxyd wieder passiviert.

Der Nachteil in der Verwendung von Flusssäure als ätzendes Additiv besteht darin, dass die Konzentration sehr genau eingehalten und kontrolliert werden muss. Eine zu hohe Konzentration würde die Metalloberfläche zu stark angreifen, durch eine zu niedrige Flusssäure-Konzentration wird keine ausreichende Reinigungswirkung erzielt.

Je nach Art der Anlagen, in denen die Stripperlösung eingesetzt werden soll, werden unterschiedliche HF-Konzentrationen eingestellt. Bei Verwendung der Stripperlösung auf Spinetchern werden üblicherweise Stripper eingesetzt, deren HF Konzentration bei 100 mg/kg liegt. Dagegen werden auf Tankanlagen Zusammensetzungen verwendet, deren HF Konzentration lediglich bei 10 mg/kg liegt.

Besonders die sehr geringe Konzentration der Lösungen zur Verwendung auf Tankanlagen macht die Prozessführung sehr aufwendig. Die Konzentration darf nur wenige ppm vom Sollwert abweichen. Dieses Ziel kann nur erreicht werden durch kontinuierliches, exaktes Messen und kontrolliertes Nachdosieren von Flusssäure. Dieses ist nur möglich, wenn die Anlage über eine Online-Analytik und ein entsprechendes Dosiersystem verfügt.

Aus der US 6 399 552 B1 ist die Verwendung von wässrigen Reinigungslösungen enthaltend HBF₄ zur Entfernung von Verunreinigungen von Leitersubstraten bekannt.

### Literatur

Merck Patent WO97/36209. Solution and Process for Removal of Sidewall Residue after Dry Etching

Ashland. Technical Note, Fluoride-Containing Strippers SEZ. Inorganic Chemical DSP

EP 0 773 480 A1, Remover solution composition for resist and method for removing resist using the same

EP 0 485 161 A1, Stripping composition and method of stripping resist from substrates

US-A-5,698,503, Stripping and cleaning composition

US-A-5,709,756, Basic stripping and cleaning composition

EP 0 596 515 B1, Alkaline photoresist stripping composition producing reduced metal corrosion

### Aufgabe

Die Aufgabe der vorliegenden Erfindung besteht darin, eine beständige Zusammensetzung oder auch "Stripperlösung" zur Entfernung von Restpolymeren, den sogenannten "sidewall-residues", zur Verfügung zu stellen, die in einem großen Konzentrationsbereich des Additivs stabile Ätzraten auf Aluminium bzw. Aluminium/ Kupferlegierungen liefert, oben beschriebene Restpolymere vollständig entfernt, ohne die Metallisierungsschichten bzw. Leiterbahnen zu beschädigen oder Korrosion zu erzeugen.

Die Lösung der Aufgabe erfolgt durch eine Zusammensetzung gemäß Anspruch 1. Bevorzugt werden diese Zusammensetzungen zum Entfernen von Restpolymeren nach dem Trockenätzen an Metallleiterzügen und Kontaktlöchern verwendet. Es ist auch somit die Verwendung dieser Zusammensetzung zum Entfernen von Restpolymeren von Aluminium oder Kupferaluminiumlegierungen Gegenstand der vorliegenden Erfindung, und zwar insbesondere die Verwendung von Zusammensetzungen, enthaltend H₂SiF₆ und/oder HBF₄ in einer Gesamtmenge von 10 - 500 mg/kg, 1 - 17 Gew.-% H₂SO₄, 1 - 15 Gew.-% H₂O₂ in wässriger Lösung. Bevorzugt werden diese Zusammensetzungen zur Restpolymerentfernung in einem Verfahrensschritt der Halbleiterherstellung unter Einsatz eines Spinetchers oder in einer Tankanlage verwendet.

Erfindungsgemäß erfolgt die Verwendung der erfindungsgemäßen Zusammensetzungen in Verfahren zur Entfernung von Restpolymeren von AI- oder Al-haltigen Leiterbahnen.

### Beschreibung der Erfindung

Wie beschrieben, stellen Schwefelsäure und Wasserstoffperoxid sowie ein fluorhaltiges, anorganisches Additiv die Hauptbestandteile eines Strippers dar. Die zur Zeit am häufigsten eingesetzte anorganische Zusammensetzung ist die oben aufgeführte DSP-Mischung, bestehend aus Schwefelsäure, Wasserstoffperoxid und als Additiv reine Flusssäure im Konzentrationsbereich von 10 bis 100 mg/kg.

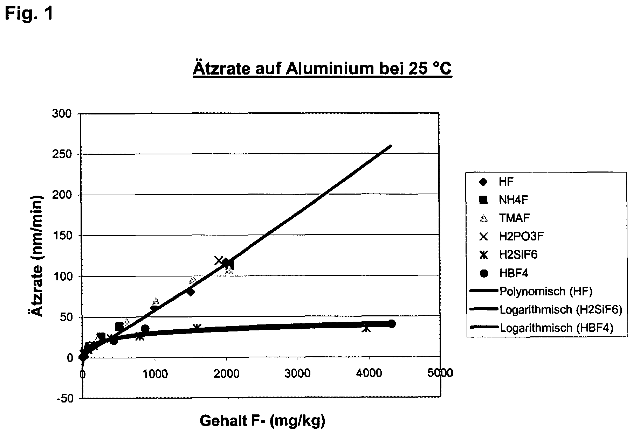

Werden statt Flusssäure Additive wie Ammoniumfluorid, Tetramethylammoniumfluorid oder Fluorphosphonsäure eingesetzt, zeigen diese gleiches Ätzverhalten auf Aluminium, d. h. eine lineare Abhängigkeit von der im Stripper vorliegenden Fluoridkonzentration. Ein solches lineares Ätzverhalten in Abhängigkeit von der Konzentration der ätzenden Komponente ist für HF, NH₄F, TMAF und H₂PO₃F in Fig. 1. dargestellt.

Die Tatsache, dass die Ätzraten all dieser Additive in einer graphischen Darstellung auf einer Geraden liegen, lässt vermuten, dass sich der Fluoridanteil in der sauren Lösung vollständig in HF umwandelt.

Das Ätzverhalten der Fluorverbindungen Hexafluorokieselsäure und Tetrafluorborsäure stellt sich dagegen vollkommen anders dar, wie Versuche gezeigt haben. Zwar steigen zunächst die Ätzraten mit steigender Konzentration an, sie bleiben aber bei weiterer Konzentrationserhöhung nahezu konstant. Dieses Verhalten ist auch aus der graphischen Darstellung in Fig. 1 zu entnehmen ist.

Obwohl nach allgemeinem Verständnis Hexafluorokieselsäure und Tetrafluorborsäure starke Säuren sind, wurde nun durch Versuche gefunden, dass durch ihren Einsatz anstelle der oben genannten Additive das Verhalten der Stripperlösungen vorteilhaft beeinflusst werden kann. Bereits wenn diese Komponenten in relativ geringen Mengen zugesetzt werden, zeigt sich dieser positive Effekt sehr deutlich. Aber nicht nur die Ätzraten lassen sich durch Zusatz von Hexafluorokieselsäure und/oder Tetrafluorborsäure in vorteilhafter Weise beeinflussen, gleichzeitig wird dadurch eine Passivierung der Oberflächen der aus Aluminium- oder Aluminiumlegierungen bestehenden Leiterbahnen gegen Korrosion erreicht.

Durch die "doppelte" Inhibitorwirkung dieser Verbindungen kann dieser zur Restpolymerentfernung notwendige Verfahrensschritt über einen längeren Zeitraum und in einem weit größeren Konzentrationsbereich mit konstanter Stripperwirkung durchgeführt werden.

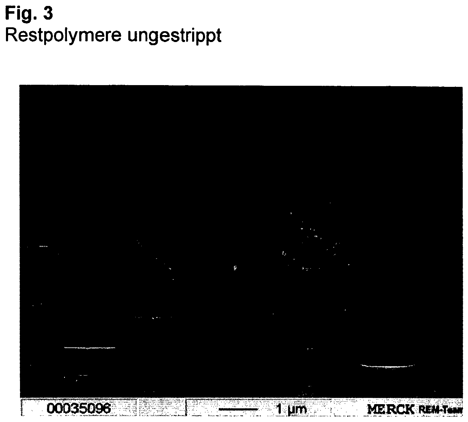

Eine fortlaufende Messung des Additivgehalts und ein Nachdosieren während des Produktionsprozesses wird damit überflüssig. Hierdurch werden Kosten für apparativen Aufwand eingespart und gleichzeitig eine größere Prozesssicherheit erzielt. Durch den Einsatz von Hexafluorokieselsäure und/oder Tetrafluorborsäure in der Zusammensetzung in Konzentrationen von 100 bis 500 mg/kg werden Restpolymere mit sehr guten Ergebnissen entfernt, was durch REM-Untersuchungen bestätigt werden kann. Gleichzeitig zeigt sich im genannten Konzentrationsbereich kein Angriff des Aluminiums oder der Aluminiumlegierungen. Die vorteilhafte Wirkung der Hexafluorokieselsäure zeigt sich im direkten Vergleich mit HF als Additiv. HF zeigt bereits ab 100 mg/kg deutliche Anätzungen (siehe Fig. 3, Bild 5).

Für die Durchführung der Versuche werden strukturierte Wafer mit folgendem Schichtaufbau verwendet:
- SiO2 (thermisches Oxid Untergrund)
- Titan-gesputtert 100 nm
- Aluminium-gesputtert (0,5 % Cu) 900 nm
- TiN-gesputtert 100 nm

Die Strukturierung der Aluminiumleiterzüge erfolgt mittels Fotolackbeschichtung, Belichten und anschließendem Entwickeln und Aushärten des Lacks durch UV-Bestrahlung.

Danach werden die Wafer auf einer LAM TCP 9600 in der Ätzkammer geätzt mit Cl₂/BCl₃ und N₂ als Ätzgase.

Die Entfernung der Fotolackschicht erfolgt mittels O₂/H₂O-Plasmabehandlung in der "Strippkammer", gefolgt von einer Warmwasserbehandlung in einer weiteren Kammer zur Chlorentfernung (Korrosionsvermeidung).

Das Verfahren zur Entfernung der Restpolymere nach dem Trockenätzen, also der Stripp-Prozess, wird zunächst in Becherglasversuchen unter reproduzierbaren Bedingungen gemäss DIN 50453 entwickelt. Anschließend wird das Verfahren auf einen Spinetcher von SEZ und einer Tankanlage AWP200 von Mattson übertragen mit folgenden Prozessparametern:

| | SEZ-Spinetcher | AWP 200 Mattson |
|---|---|---|
| Ätzen: | 45 - 60 s bei 25°C | 45 - 90 s bei 25 °C |
| Spülen mit | | |
| Reinstwasser: | 30 s bei RT | 10 min. bei RT |
| Trocknen: | N₂ | Marangoni |

Für die ersten Versuche wird eine Zusammensetzung verwendet, die der aktuell verwendeten DSP-Mischung entspricht, einer wässrigen Lösung von Schwefelsäure mit einer Konzentration im Bereich zwischen 12 bis 17 Gew.-% sowie Wasserstoffperoxid in einer Konzentration im Bereich von 2 bis 4 Gew.-%. Dabei werden H₂SiF₆ und HBF₄ einzeln aber auch die Kombination der beiden Verbindungen als Fluorid-Ionen-Lieferanten eingesetzt.

Diese Versuche zeigen, dass durch den Zusatz der einzelnen Fluorid-Ionen-Lieferanten H₂SiF₆ und HBF₄ aber auch in Kombination miteinander eine gute Entfernung der Restpolymere erzielt wird, wobei durch H₂SiF₆ eine bessere Passivierung hervorgerufen wird. Aufgrund dieses Versuchsergebnisses und aufgrund seiner besseren Handhabbarkeit ist daher die Verwendung von H₂SiF₆ zu bevorzugen.

Zur Restpolymerentfernung nach dem Trockenätzen sind an sich Lösungen geeignet, welche H₂SO₄ in einer Konzentration im Bereich von 1 bis 17 Gew.-% enthalten. Besonders gute Ergebnisse werden mit Zusammensetzungen erzielt, in denen 12 bis 17 Gew.-% H₂SO₄ enthalten sind.

Zusammensetzungen, die H₂O₂ im Konzentrationsbereich zwischen 1 bis 12 Gew.-% enthalten, haben sich für die Restpolymerentfernung als geeignet erwiesen. Bevorzugt werden Zusammensetzungen eingesetzt, welche H₂O₂ in einer Konzentration im Bereich von 2 bis 4 Gew.-% enthalten.

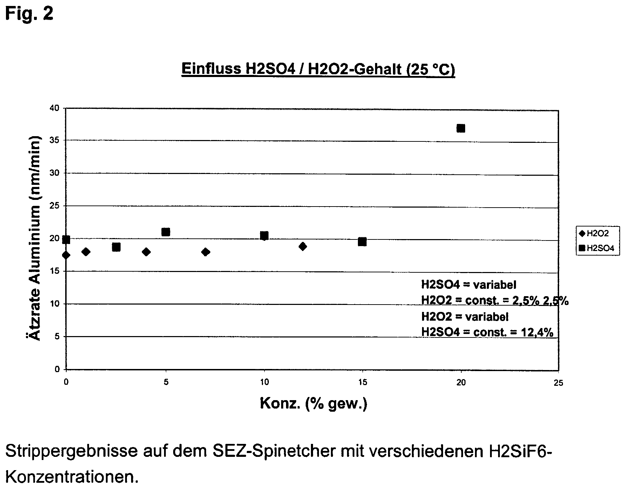

In diesen Konzentrationsbereichen sind die Ätzraten auf Aluminium nahezu konstant und werden nur vom Gehalt des Additivs bestimmt. Fig. 2 zeigt die Abhängigkeit der Ätzraten auf Aluminium bei einem konstanten Gehalt an H₂SiF₆ von 500 mg/kg.

Als besonders geeignet haben sich Zusammensetzungen erwiesen, in denen 12 bis 17 Gew.-% H₂SO₄, 2 bis 4 Gew.-% H₂O₂ und 100 bis 500 mg/kg H₂SiF₆ enthalten sind. Bevorzugt ist entsprechende Zusammensetzung, worin als Fluorid-Lieferant H₂SiF₆ in Kombination mit HBF₄ enthalten ist und ihre Gesamtmenge beider Verbindungen 100 bis 500 mg/kg beträgt. Eine weitere bevorzugte Ausgestaltung der Erfindung umfasst Zusammensetzungen, die als einzige fluorhaltige Verbindung HBF₄ in einer Menge von 100 bis 500 mg/kg enthalten.

Durch Versuche wurde gefunden, dass entsprechende Zusammensetzungen besonders gut geeignet sind zum Entfernen von Restpolymeren nach dem Trockenätzen an Metallleiterzügen.

Insbesondere eignen sich diese wässrigen Zusammensetzungen zum Entfernen von Restpolymeren von Aluminium, ohne das Metall anzugreifen.

Während sich in den bisher als Stripper eingesetzten DSP-Mischungen mit reiner HF als Additiv gegenüber den erfindungsgemäßen Zusammensetzungen bei kontinuierlicher Prozessführung der Gehalt an HF laufend verringert, was die Reinigungswirkung negativ beeinträchtigt, scheint durch H₂SiF₆ oder HBF₄ als wirksames Additiv verbrauchtes HF gemäss einer Gleichgewichtsreaktion kontinuierlich nachgeliefert zu werden, so dass die gewünschte Konzentration über einen längeren Zeitraum offenbar konstant bleibt. Durch eine auf diese Weise stabilisierte Lösung ist man in der Lage, zum einen die Prozesssicherheit deutlich zu verbessern und zum anderen Kosten einzusparen, da auf ein apparativ aufwendiges Online-Kontroll- und Dosiersystem verzichtet werden kann. Weiterhin wirken die erfindungsgemäßen Fluorid-Ionen-Lieferanten im Vergleich zu reinen HF-Lösungen wesentlich weniger korrosiv sowohl gegenüber verwendeten Lagerbehältern als auch den Produktionsanlagen, so dass auch in dieser Hinsicht die erfindungsgemäßen Fluorid-Ionen-Lieferanten einen erheblichen Beitrag zur Prozesssicherheit beitragen.

Zur Veranschaulichung und zum besseren Verständnis der Erfindung werden im folgenden Beispiele gegeben. Aufgrund der generellen Gültigkeit der vorliegenden Erfindung in den beschriebenen Grenzen sind diese Beispiele nicht dazu geeignet, die Erfindung nur auf die in den Beispielen gegebenen Werte zu beschränken.

### Beispiele:

### Beispiel 1:

Geätzte Wafer mit dem zuvor beschriebenen Schichtaufbau wurden auf dem SEZ-Spinetcher prozessiert. Bei dieser Technologie handelt es sich um einen Einzelwaferprozess, bei dem der Wafer in einer Prozesskammer waagerecht liegend in Drehung versetzt wird und über eine Düse mit der Ätzflüssigkeit angeströmt wird. Dabei fährt der Düsenarm in waagerechter Hin- und Herbewegung über die Waferoberfläche. Nach dem Ätzprozess erfolgt ein Spülprozess mit Reinstwasser nach dem gleichen Prinzip. Zum Trocknen wird der Wafer zum Schluss unter hoher Umdrehungszahl mit N₂ trockengeblasen.
Schritt 1: Strippen
Zusammensetzung der Mischung:

| | |
|---|---|
| Schwefelsäure: | 12,0 % gew. |
| Wasserstoffperoxid: | 2,4 % gew. |

| | |
|---|---|
| H2SiF6: | 500 mg/kg |

600 U/min, 1 l/min Durchfluss, 25 °C, 30 sek.
Schritt 2: Spülen mit Reinstwasser
600 U/min, 1 l/min Durchfluss, 25 °C, 30 sek.
Schritt 3: Trockenschleudern mit N2-Abblasen
2000 U/min, 150 l/min.

Fig. 3, zeigt die vollständig gereinigte Oberfläche, ohne Angriff der Metallisierung. Bei Konzentrationen oberhalb 500 mg/kg H2SiF6 wird die Metallisierung angeätzt, siehe Fig. 3, Bild 4 mit 1000 mg/kg.

### Beispiel 2:

Die gleichen Wafer wie in Beispiel 1 wurden auf einer Tankanlage AWP200 von Mattson prozessiert.
Schritt 1: Strippen
Zusammensetzung der Mischung:

| | |
|---|---|
| Schwefelsäure: | 12,0 % gew |
| Wasserstoffperoxid: | 2,4 % gew. |
| H2SiF6: | 100 mg/kg |

15 l/min. Rezirkulation, 25 °C, 45 s
Schritt 2: Spülen mit Reinstwasser
35 l/min Durchfluss, 25 °C, 10 min.
Schritt 3: Marangonitrockner

Fig. 3, zeigt die vollständig gereinigte Oberfläche, ohne Angriff der Metallisierung.

### Beispiel 3

Die gleichen Wafer wie in Beispiel 1 wurden in einem Becherglas prozessiert. Zur besseren Charakterisierung des Strippprozesses wurden Wafer mit sehr dicken Polymerschichten verwendet.
Schritt 1: Strippen
Zusammensetzung der Mischung:

| | |
|---|---|
| Schwefelsäure: | 12 Gew.-% |
| Wasserstoffperoxid: | 2,4 Gew.-% |
| H₂SiF₆: | 100 mg/kg |
| Önanthsäure: | 80 mg/kg |

100 U/min. 25 °C, 60 sek.
Schritt 2: Spülen mit Reinstwasser im Becherglas
25 °C, 5 min.
Schritt 3: Trocknen im Stickstoffofen
100 °C, 10 min

In Fig. 12 ist zu erkennen, dass die Polymere bis auf eine dünne Restschicht entfernt sind.

### Vergleichsbeispiel zu Beispiel 3

Als Referenz wurde ein gleicher Wafer mit der gleichen Zusammensetzung, jedoch ohne Tensidzusatz wie vorher prozessiert.

In Fig. 13 erkennt man eine wesentlich dickere Polymerschicht.

Durch den Tensidzusatz wird also die Oberfläche besser benetzt, was die Strippwirkung positiv beeinflusst.

In den im Anhang gezeigten REM-Aufnahmen sind die Ergebnisse der Restpolymerentfernung unter Verwendung der erfindungsgemäßen Zusammensetzungen festgehalten. Die Ergebnisse sind durch das "Strippen" auf einem SEZ-Spinetcher unter Verwendung verschiedner H₂SiF₆-Konzentrationen erzielt worden:

Fig. 3 zeigt einen Ausschnitt eines Wafers mit Aluminium-Leiterbahnen vor der Behandlung.

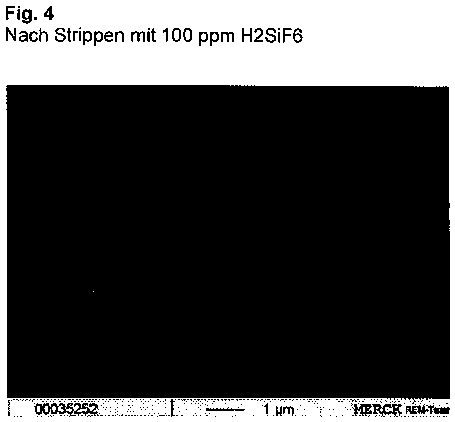

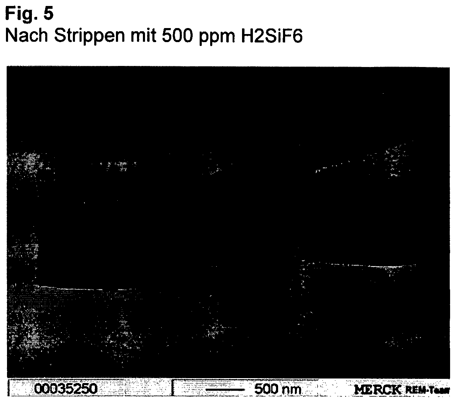

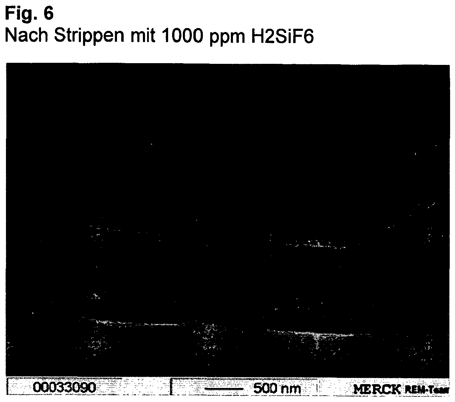

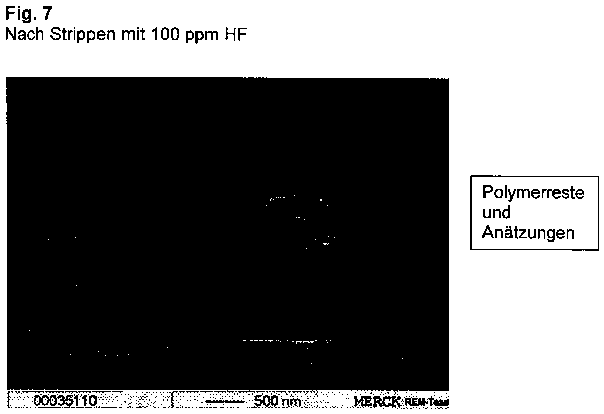

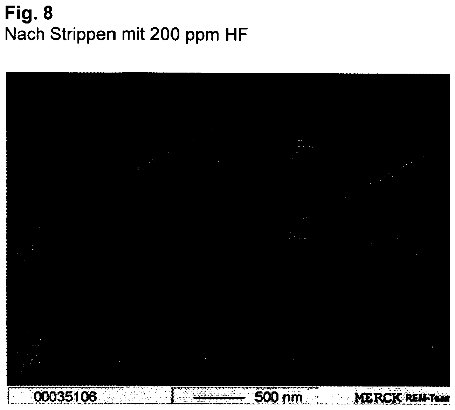

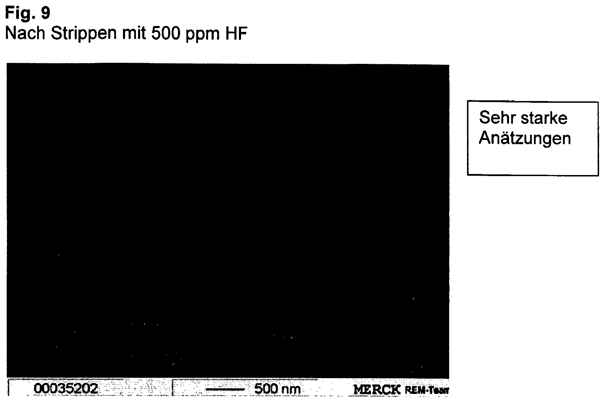

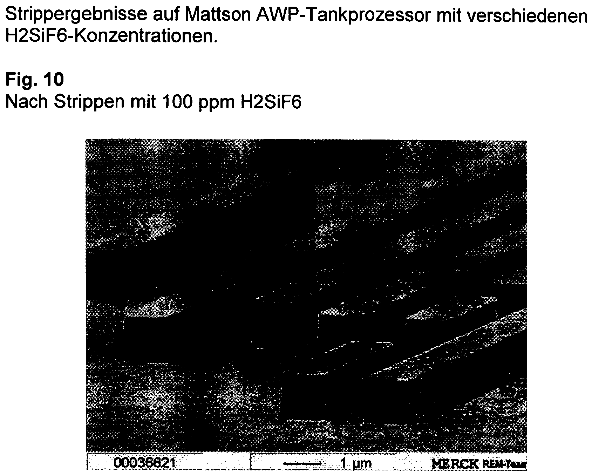

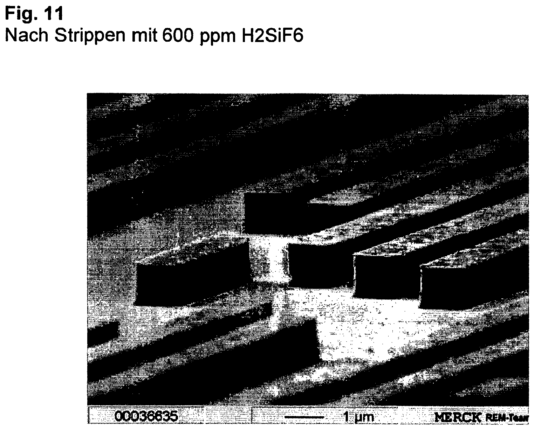

Fig. 4 zeigt einen entsprechenden Waferausschnitt nach dem Strippen mit einer Zusammensetzung, enthaltend 100 ppm H₂SiF₆, Fig. 5 mit 500 ppm H₂SiF₆, Fig. 6 mit 1000 ppm H₂SiF₆. Die Figurenen 4 bis 6 zeigen Restpolymer-freie Leiterbahnen. Im Vergleich dazu werden in den Fig. 7 - 9 Ergebnisse, gezeigt, die unter denselben Bedingungen erhalten worden sind, jedoch unter Verwendung von verschiedenen HF-Konzentrationen: Fig. 7 100 ppm HF, Fig. 8 200 ppm HF und Fig. 9 500 ppm HF. Bei Verwendung von 100 ppm HF sind noch Polymerreste und Anätzungen zu erkennen. Die Verwendung von 200 ppm HF führt zwar zu einer nahezu vollständigen Entfernung der Restpolymere aber auch zu einer Zunahme der Anätzungen gegenüber der Verwendung von 100 ppm HF. Bei der Verwendung von Zusammensetzungen mit 500 ppm HF werden sehr starke Anätzungen der Metallleiterbahnen gefunden. Die Figuren 10 und 11 zeigen Ergebnisse, die durch die Restpolymerentfernung in einem Mattson AWP-Tankprozessor erhalten wurden: Fig. 10 unter Verwendung von 100 ppm H₂SiF₆ und Fig. 11 unter Verwendung von 600 ppm H₂SiF₆. Auch in diesen Fällen wird eine sehr gute Restpolymerentfernung gefunden, wobei sich die Anätzung sogar bei 600 ppm in vertretbaren Grenzen hält.

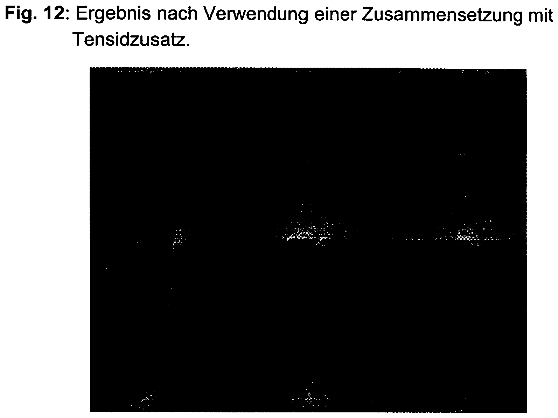

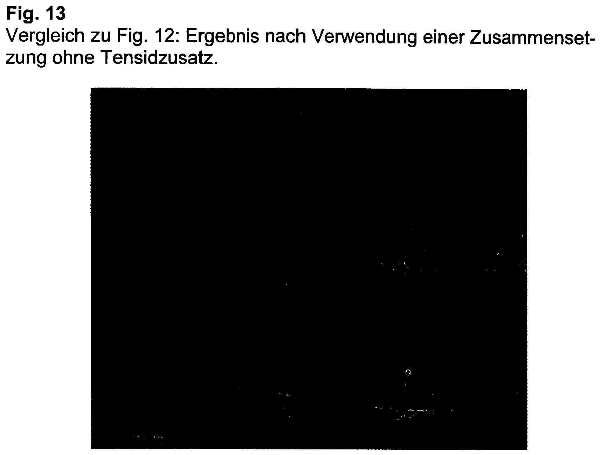

Fig. 12 zeigt Leiterbahnen nach einer Behandlung mit einer Stripperlösung mit einem Gehalt an 12 Gew.-% H₂SO₄, 2,4 Gew.-% H₂O₂, 100 ppm H₂SiF₆ und Tensidzusatz. Im Vergleich dazu zeigt Fig. 13 Leiterbahnen nach Behandlung mit einer entsprechenden Stripperlösung wie bei Fig. 12 jedoch ohne Tensidzusatz.

## Patentansprüche

1. Zusammensetzung für die Halbleiterherstellung, enthaltend H₂SiF₆ und/oder HBF₄ in einer Gesamtmenge von 10 - 500 mg/kg, 12 - 17 Gew.-% H₂SO₄, 2-4 Gew.-% H₂O₂ in wässriger Lösung.

2. Verwendung einer Zusammensetzung gemäß Anspruch 1, als Restpolymerentferner in einem Verfahrensschritt der Halbleiterherstellung.

3. Verwendung gemäß Anspruch 2 zur Entfernung von Restpolymeren von AI- oder Al-haltigen Leiterbahnen.

4. Verwendung gemäß Anspruch 2 zum Entfernen von Restpolymeren nach dem Trockenätzen an Metallleiterzügen und Kontaktlöchern.

5. Verwendung einer Zusammensetzung gemäß Anspruch 1 zum Entfernen von Restpolymeren von Aluminium oder Kupferaluminiumlegierungen.

6. Verwendung gemäß einem oder mehreren der Ansprüche 2-5 zur Restpolymerentfernung in einem Verfahrensschritt der Halbleiterherstellung unter Einsatz eines Spinetchers oder in einer Tankanlage.

7. Verfahren zur Entfernung von Restpolymeren von AI- oder Al-haltigen Leiterbahnen, **dadurch gekennzeichnet, dass** zur Entfernung von Restpolymeren eine Zusammensetzung gemäß Anspruch 1 verwendet wird.

## Claims

1. A composition for semiconductor production, comprising H₂SiF₆ and/or HBF₄ in a total amount of 10-500 mg/kg, 12%-17% by weight of H₂SO₄, 2%-4% by weight of H₂O₂ in aqueous solution.

2. The use of a composition according to claim 1 as residual polymer remover in a process step of semiconductor production.

3. The use according to claim 2 for removal of residual polymers from Al or Al-containing conductor tracks.

4. The use according to claim 2 for removal of residual polymers after dry etching on metal conductor tracks and contact holes.

5. The use of a composition according to claim 1 for removal of residual polymers from aluminum or copper-aluminum alloys.

6. The use according to one or more of claims 2-5 for residual polymer removal in a process step of semiconductor production using a spin etcher or in a tank system.

7. A process for removing residual polymers from Al or Al-containing conductor tracks, which comprises removing residual polymers by using a composition according to claim 1.

## Revendications

1. Composition pour la fabrication de semi-conducteurs, contenant H₂SiF₆ et/ou HBF₄ en une quantité totale de 10 à 500 mg/kg, 12 à 17 % en poids d'H₂SO₄, 2 à 4 % en poids d'H₂O₂ dans une solution aqueuse.

2. Utilisation d'une composition selon la revendication 1 en tant qu'agent d'élimination de polymères résiduels lors d'une étape de procédé de la fabrication de semi-conducteurs.

3. Utilisation selon la revendication 2, pour l'élimination de polymères résiduels d'Al ou de pistes conductrices contenant Al.

4. Utilisation selon la revendication 2, pour l'élimination de polymères résiduels après la gravure à sec de conducteurs métalliques et de trous de contact.

5. Utilisation d'une composition selon la revendication 1 pour l'élimination de polymères résiduels d'aluminium ou d'alliages cuivre-aluminium.

6. Utilisation selon une ou plusieurs des revendications 2 à 5 pour l'élimination de polymères résiduels lors d'une étape de procédé de la fabrication de semi-conducteurs en utilisant un SpinEtcher ou dans une unité à réservoir.

7. Procédé d'élimination de polymères résiduels d'Al ou de pistes conductrices contenant Al, **caractérisé en ce qu'**une composition selon la revendication 1 est utilisée pour l'élimination de polymères résiduels.
